# EUROPEAN PATENT APPLICATION

(11) **EP 4 598 293 A1**
(43) Date of publication of application: **06.08.2025**
(21) Application number: 23882973.3
(22) Date of filing: 16.10.2023
(51) Int. Cl.: H05K 9/00, H04M 1/02

(54) **ELECTRONIC DEVICE COMPRISING SHIELD CAN**

(30) Priority: 28.10.2022 KR 20220141902; 18.11.2022 KR 20220155864
(71) Applicant: Samsung Electronics Co., Ltd., Suwon-si, Gyeonggi-do 16677 (KR)
(72) Inventor: KO, Hyeonmin, Suwon-si Gyeonggi-do 16677 (KR); SUNG, Euisuck, Suwon-si Gyeonggi-do 16677 (KR); KIM, Byungjoon, Suwon-si Gyeonggi-do 16677 (KR); PARK, Changkyu, Suwon-si Gyeonggi-do 16677 (KR); SON, Junghan, Suwon-si Gyeonggi-do 16677 (KR)
(74) Representative: HGF
(86) International application number: PCT/KR2023/015914
(87) International publication number: WO 2024/090866

(57) **Abstract**

An electronic device according to one embodiment may comprise: a printed circuit board; a shield can disposed on the printed circuit board; and a solder in contact with the printed circuit board and the shield can. The shield can may comprise: a base; and a sidewall disposed along the edge of the base. The sidewall may comprise: a first support portion; a second support portion; and a connection portion which connects the first support portion and the second support portion and is at least partially bent. Each of the first support portion and the second support portion may comprise a flange portion facing the outside of the shield can from a location adj acent to the printed circuit board. The connection portion may have a flat shape at a location adjacent to the printed circuit board.

## Description

### [Technical Field]

Embodiments to be described later relate to an electronic device comprising a shield can.

### [Background Art]

A small electronic device such as a smart phone or a tablet personal computer (PC) may include electronic components in the electronic device to implement various functions of the electronic device. In order to reduce damage to the electronic components due to a radio wave generated by operating the electronic components, the electronic device may include a shield can shielding the electronic components.

### [Disclosure]

### [Technical Solution]

An electronic device according to an embodiment may comprise a printed circuit board, a shield can disposed on the printed circuit board, and a solder in contact with the printed circuit board and the shield can to fasten the shield can to the printed circuit board. The shield can may include a base faced away from the printed circuit board and a sidewall disposed along a periphery of the base. The sidewall may include a first supporting portion, a second supporting portion, and a connecting portion that connects the first supporting portion and the second supporting portion and is at least partially bent, the first supporting portion and the second supporting portion are for supporting the shield can using the printed circuit board. Each of the first supporting portion and the second supporting portion includes a flange portion facing an outside of the shield can at a position adjacent to the printed circuit board. The connecting portion may have a planar shape at a position adjacent to the printed circuit board.

An electronic device according to an embodiment may comprise a printed circuit board, a shield can disposed on the printed circuit board, and a solder in contact with the printed circuit board and the shield can to fasten the shield can to the printed circuit board. The shield can may include a base faced away from the printed circuit board and a sidewall disposed along a periphery of the base. The sidewall may include a first supporting portion, a second supporting portion, and a connecting portion that connects the first supporting portion and the second supporting portion and is at least partially bent, the first supporting portion and the second supporting portion are for supporting the shield can using the printed circuit board. Each of the first supporting portion and the second supporting portion may include a flange portion facing an outside of the shield can at a position adjacent to the printed circuit board. The connecting portion may be perpendicular to the printed circuit board. The solder may include a first region, disposed along a periphery adjacent to the printed circuit board of the sidewall and being in contact with an outer surface of the shield can, and a second region in contact with an inner surface of the shield can.

A shield can may comprise a base and a sidewall. The sidewall may include a first supporting portion, a second supporting portion, and a connecting portion that connects the first supporting portion and the second supporting portion and is at least partially bent, the first supporting portion and the second supporting portion are disposed along a periphery of the base and are for supporting the shield can. Each of the first supporting portion and the second supporting portion may include a flange portion that is spaced apart from the base and includes a step. The connecting portion has a planar shape at a position adjacent to the flange portion.

### [Description of the Drawings]

FIG. 1 is a block diagram of an electronic device in a network environment according to an embodiment.
FIG. 2 is a diagram illustrating an electronic device according to an embodiment.
FIG. 3A is an exploded perspective view of an electronic device according to an embodiment.
FIG. 3B is an enlarged view of an exemplary electronic device in which a region A of FIG. 3A is enlarged.
FIG. 3C is a cross-sectional view of an exemplary electronic device cut along line B-B' of FIG. 3B.
FIG. 4A illustrates a portion of a shield can of an exemplary electronic device.
FIG. 4B is a cross-sectional view of a shield can of an electronic device cut along line C-C' of FIG. 4A.
FIG. 4C illustrates a portion of a shield can of an exemplary electronic device.
FIG. 5 illustrates a portion of a shield can of an exemplary electronic device.
FIG. 6 is a flow chart illustrating a manufacturing process of an exemplary shield can.

### [Mode for Invention]

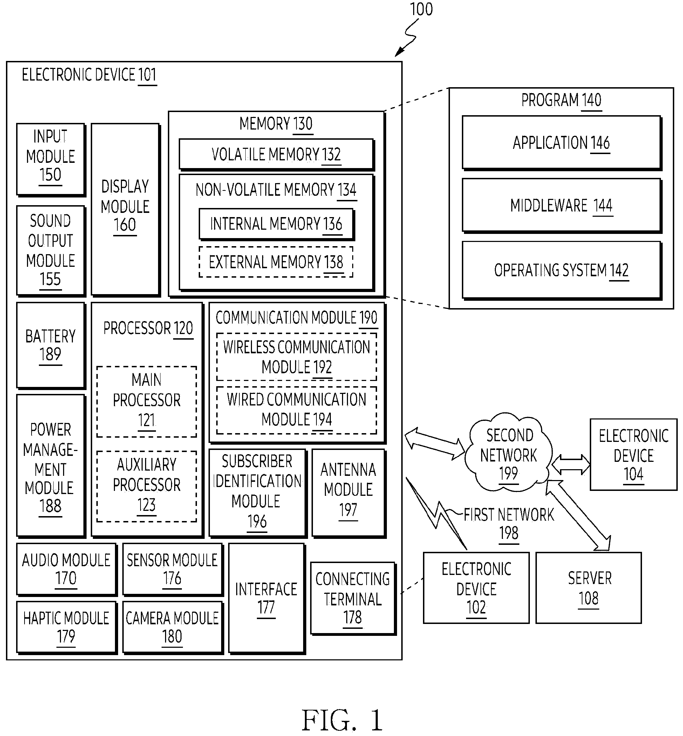

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such leaming may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

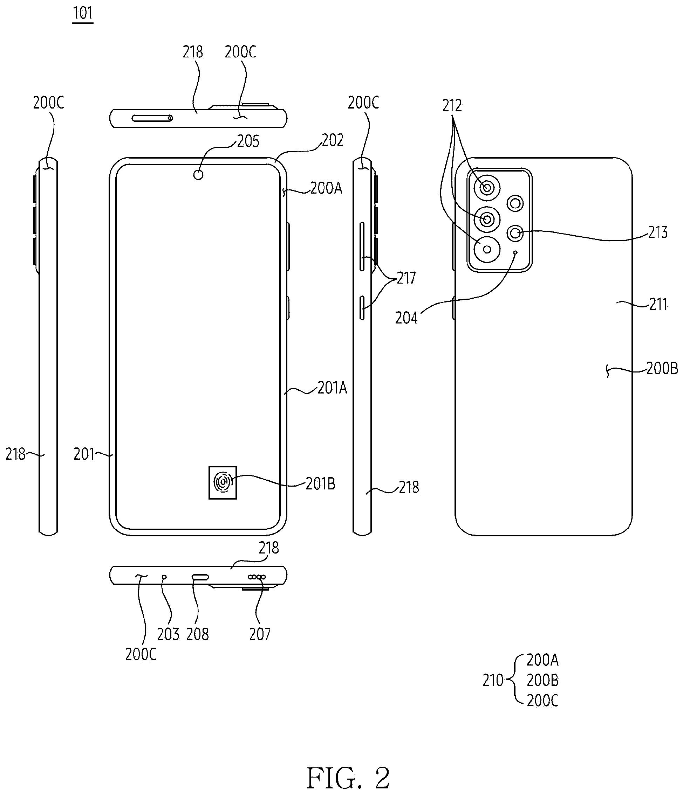

FIG. 2 is a diagram illustrating an electronic device according to an embodiment.

Referring to FIG. 2, an electronic device 101 according to an embodiment may include a housing 210 forming an exterior of the electronic device 101. For example, the housing 210 may include a front surface 200A, a rear surface 200B, and a side surface 200C surrounding a space between the front surface 200A and the rear surface 200B. According to an embodiment, the housing 210 may refer to a structure forming at least a portion of the front surface 200A, the rear surface 200B, and/or the side surface 200C.

The electronic device 101 according to an embodiment may include a substantially transparent front plate 202. According to an embodiment, the front plate 202 may form at least a portion of the front surface 200A. According to an embodiment, the front plate 202 may include, for example, a glass plate or a polymer plate including various coating layers, but is not limited thereto.

The electronic device 101 according to an embodiment may include a substantially opaque rear plate 211. According to an embodiment, the rear plate 211 may form at least a portion of the rear surface 200B. According to an embodiment, the rear plate 211 may be formed of coated or colored glass, ceramic, polymer, metal (e.g., aluminum, stainless steel (STS), or magnesium), or a combination of at least two of the above materials.

The electronic device 101 according to an embodiment may include a side bezel structure (or a side member) 218. According to an embodiment, the side bezel structure 218 may form at least a portion of the side surface 200C of the electronic device 101 by being coupled with the front plate 202 and/or the rear plate 211. For example, the side bezel structure 218 may form the entire side surface 200C of the electronic device 101, and for another example, the side bezel structure 218 may form the side surface 200C of the electronic device 101 together with the front plate 202 and/or the rear plate 211.

Unlike the illustrated embodiment, in case that the side surface 200C of the electronic device 101 is partially formed by the front plate 202 and/or the rear plate 211, the front plate 202 and/or the rear plate 211 may include a region that is bent toward the rear plate 211 and/or the front plate 202 at its periphery and seamlessly extends. The extended region of the front plate 202 and/or the rear plate 211 may be, for example, located at both ends of a long edge of the electronic device 101, but is not limited by the above-described example.

According to an embodiment, the side bezel structure 218 may include a metal and/or a polymer. According to an embodiment, the rear plate 211 and the side bezel structure 218 may be integrally formed and may include the same material (e.g., a metal material such as aluminum), but are not limited thereto. For example, the rear plate 211 and the side bezel structure 218 may be formed in separate configurations and/or may include different materials.

According to an embodiment, the electronic device 101 may include at least one of a display 201, audio modules 203, 204, and 207, a sensor module (not illustrated), camera modules 205, 212, and 213, a key input device 217, a light emitting device (not illustrated), and/or a connector hole 208. According to an embodiment, the electronic device 101 may omit at least one (e.g., the key input device 217 or the light emitting device (not illustrated)) of the components, or may further include another component.

According to an embodiment, the display 201 may be visually exposed through a significant portion of the front plate 202. For example, at least a portion of the display 201 may be visible through the front plate 202 forming the front surface 200A. According to an embodiment, the display 201 may be disposed on a back surface of the front plate 202.

According to an embodiment, an outer shape of the display 201 may be formed substantially the same as an outer shaper of the front plate 202 adjacent to the display 201. According to an embodiment, in order to expand an area in which the display 201 is visually exposed, a gap between an outer edge of the display 201 and an outer edge of the front plate 202 may be substantially the same.

According to an embodiment, the display 201 (or the front surface 200A of the electronic device 101) may include a screen display region 201A. According to an embodiment, the display 201 may provide visual information to a user through the screen display region 201A. In the illustrated embodiment, it is described that the screen display region 201A is located inside the front surface 200A by being spaced apart from the outer edge of the front surface 200A, when the front surface 200A is viewed from the front, but is not limited thereto. In another embodiment, when the front surface 200A is viewed from the front, at least a portion of a periphery of the screen display region 201A may substantially coincide with the periphery of the front surface 200A (or the front plate 202).

According to an embodiment, the screen display region 201A may include a sensing region 201B configured to obtain biometric information of the user. Herein, the meaning of "the screen display region 201A includes the sensing region 201B" may be understood as at least a portion of the sensing region 201B being overlapped with the screen display region 201A. For example, the sensing region 201B may mean a region capable of displaying visual information by the display 201 like another region of the screen display region 201A, and additionally obtaining biometric information (e.g., fingerprint) of the user. According to an embodiment, the sensing region 201B may be formed in the key input device 217.

According to an embodiment, the display 201 may include a region where a first camera 205 is located. According to an embodiment, an opening is formed in the region of the display 201, and a first camera 205 (e.g., a punch hole camera) may be at least partially disposed in the opening to face the front surface 200A. In this case, the screen display region 201A may surround at least a portion of a periphery of the opening. According to an embodiment, a first camera 205 (e.g., an under display camera (UDC)) may be disposed under the display 201 to overlap the region of the display 201. In this case, the display 201 may provide visual information to the user through the region, and additionally, the first camera 205 may obtain an image corresponding to a direction facing the front surface 200A through the region of the display 201.

According to an embodiment, the display 201 may be combined or disposed adjacent to touch sensing circuitry, a pressure sensor capable of measuring an intensity (a pressure) of a touch, and/or a digitizer that detects a magnetic field type stylus pen.

According to an embodiment, the audio modules 203, 204, or 207 may include microphone holes 203 or 204 and a speaker hole 207.

According to an embodiment, the microphone holes 203 and 204 may include a first microphone hole 203 formed in a partial region of the side surface 200C and a second microphone hole 204 formed in a partial region of the rear surface 200B. A microphone (not illustrated) for obtaining an external sound may be disposed inside the microphone holes 203 and 204. The microphone may include a plurality of microphones to detect a direction of the sound.

According to an embodiment, a second microphone hole 204 formed in a partial region of the rear surface 200B may be disposed adjacent to the camera modules 205, 212, and 213. For example, the second microphone hole 204 may obtain a sound according to an operation of the camera modules 205, 212, and 213. However, it is not limited to thereto.

According to an embodiment, the speaker hole 207 may include an external speaker hole 207 and a call receiver hole (not illustrated). The external speaker hole 207 may be formed in a portion of the side surface 200C of the electronic device 101. According to an embodiment, the external speaker hole 207 and the microphone hole 203 may be implemented as one hole. Although not illustrated, the call receiver hole (not illustrated) may be formed in another portion of the side surface 200C. For example, the call receiver hole may be formed on an opposite side of the external speaker hole 207 from the side surface 200C. For example, based on the illustration of FIG. 2, the external speaker hole 207 may be formed on the side surface 200C corresponding to a lower end of the electronic device 101, and the call receiver hole may be formed on the side surface 200C corresponding to an upper end of the electronic device 101. However, it is not limited thereto, and according to an embodiment, the call receiver hole may be formed at a position other than the side surface 200C. For example, the call receiver hole may be formed by a space separated between the front plate 202 (or the display 201) and the side bezel structure 218.

According to an embodiment, the electronic device 101 may include at least one speaker (not illustrated) configured to output a sound to the outside of the housing through the external speaker hole 207 and/or the call receiver hole (not illustrated).

According to an embodiment, the sensor module (not illustrated) may generate an electrical signal or a data value corresponding to an operating state inside the electronic device 101 or an external environmental state. For example, the sensor module may include at least one of a proximity sensor, an HRM sensor, a fingerprint sensor, a gesture sensor, a gyro sensor, a barometric pressure sensor, a magnetic sensor, an acceleration sensor, a grip sensor, a color sensor, an IR sensor, a biometric sensor, a temperature sensor, a humidity sensor, or an illuminance sensor.

According to an embodiment, the camera modules 205, 212, and 213 may include the first camera 205 disposed to face the front 200A of the electronic device 101, the second camera 212 disposed to face the rear 200B, and a flash 213.

According to an embodiment, the second camera 212 may include a plurality of cameras (e.g., a dual camera, a triple camera, or a quad camera). However, the second camera 212 is not limited to including the plurality of cameras, and may include one camera.

According to an embodiment, the first camera 205 and the second camera 212 may include one or more lenses, an image sensor, and/or an image signal processor.

According to an embodiment, the flash 213 may include, for example, a light emitting diode or a xenon lamp. According to an embodiment, two or more lenses (an infrared camera, and a wide-angle and telephoto lenses) and image sensors may be disposed on a surface of the electronic device 101.

According to an embodiment, the key input device 217 may be disposed on the side surface 200C of the electronic device 101. According to an embodiment, the electronic device 101 may not include some or all of the key input device 217, and the key input device 217 that is not included may be implemented in another form, such as a soft key, on the display 201.

According to an embodiment, the connector hole 208 may be formed on the side surface 200C of the electronic device 101 so that a connector of an external device may be accommodated. A connection terminal electrically connected with the connector of the external device may be disposed in the connector hole 208. The electronic device 101 according to an embodiment may include an interface module for processing an electrical signal transmitted and received through the connection terminal.

According to an embodiment, the electronic device 101 may include the light emitting device (not illustrated). For example, the light emitting device (not illustrated) may be disposed on the front surface 200A of the housing. The light emitting device (not illustrated) may provide state information of the electronic device 101 in an optical form. According to an embodiment, the light emitting device (not illustrated) may provide a light source linked with an operation of the first camera 205. For example, the light emitting device (not illustrated) may include an LED, an IR LED, and/or a xenon lamp.

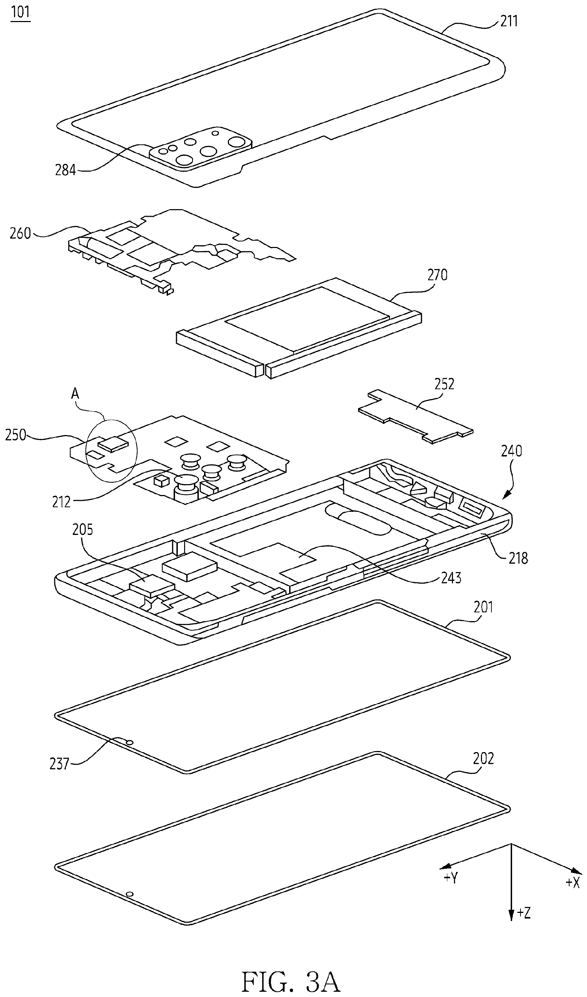

FIG. 3A is an exploded perspective view of an electronic device according to an embodiment.

Hereinafter, an overlapping description of a configuration having the same reference numerals as the above-described configuration will be omitted.

Referring to FIG. 3A, an electronic device 101 according to an embodiment may include a frame structure 240, a first printed circuit board 250, a second printed circuit board 252, a cover plate 260, and a battery 270.

According to an embodiment, the frame structure 240 may include a side bezel structure 218 forming an exterior (e.g., the side surface 200C of FIG. 2) of the electronic device 101 and a supporting portion 243 extending inward from the side bezel structure 218. According to an embodiment, the frame structure 240 may be disposed between a display 201 and a rear plate 211. According to an embodiment, the side bezel structure 218 of the frame structure 240 may surround a space between the rear plate 211 and a front plate 202 (and/or the display 201), and the supporting portion 243 of the frame structure 240 may extend from the side bezel structure 218 in the space.

According to an embodiment, the frame structure 240 may support or accommodate other components included in the electronic device 101. For example, the display 201 may be disposed on a surface of the frame structure 240 facing a direction (e.g., a +z direction), and the display 201 may be supported by the supporting portion 243 of the frame structure 240. For example, the first printed circuit board 250, the second printed circuit board 252, the battery 270, and a second camera 212 may be disposed on another surface of the frame structure 240 facing an opposite direction (e.g., a -z direction) to the direction. The first printed circuit board 250, the second printed circuit board 252, the battery 270, and the second camera 212 may be respectively seated in a recess defined by the side bezel structure 218 and/or the supporting portion 243 of the frame structure 240.

According to an embodiment, the first printed circuit board 250, the second printed circuit board 252, and the battery 270 may be coupled with the frame structure 240, respectively. For example, the first printed circuit board 250 and the second printed circuit board 252 may be fixedly disposed in the frame structure 240 through a coupling member such as a screw. For example, the battery 270 may be fixedly disposed in the frame structure 240 through an adhesive member (e.g., a double-sided tape). However, it is not limited by the above-described example.

According to an embodiment, the cover plate 260 may be disposed between the first printed circuit board 250 and the rear plate 211. According to an embodiment, the cover plate 260 may be disposed on the first printed circuit board 250. For example, the cover plate 260 may be disposed on a surface of the first printed circuit board 250 facing the -z direction.

According to an embodiment, the cover plate 260 may at least partially overlap the first printed circuit board 250 with respect to the z-axis. According to an embodiment, the cover plate 260 may cover at least a partial region of the first printed circuit board 250. Accordingly, the cover plate 260 may protect the first printed circuit board 250 from a physical impact or prevent the connector coupled to the first printed circuit board 250 from being separated.

According to an embodiment, the cover plate 260 may be fixedly disposed on the first printed circuit board 250 through a coupling member (e.g., a screw), or may be coupled to the frame structure 240 together with the first printed circuit board 250 through the coupling member.

According to an embodiment, the display 201 may be disposed between the frame structure 240 and the front plate 202. For example, the front plate 202 may be disposed on a side (e.g., the +z direction) of the display 201, and the frame structure 240 may be disposed on another side (e.g., the -z direction).

According to an embodiment, the front plate 202 may be coupled with the display 201. The front plate 202 and the display 201 may be adhered to each other through an optical adhesive member (e.g., optically clear adhesive (OCA) or optically clear resin (OCR)) interposed therebetween.

According to an embodiment, the front plate 202 may be coupled with the frame structure 240. For example, the front plate 202 may include an outer edge portion extending outside the display 201 when viewed in the z-axis direction, and may be attached to the frame structure 240 through an adhesive member (e.g., a double-sided tape) disposed between the outer edge portion of the front plate 202 and the frame structure 240 (e.g., the side bezel structure 218). However, it is not limited by the above-described example.

According to an embodiment, a processor, memory, and/or an interface may be mounted on the first printed circuit board 250 and/or the second printed circuit board 252. The processor may include, for example, one or more of a central processing unit, an application processor, a graphic processing unit, an image signal processor, a sensor hub processor, or a communication processor. The memory may include, for example, volatile memory or non-volatile memory. The interface may include, for example, a high definition multimedia interface (HDMI), a universal serial bus (USB), an SD card interface, and/or an audio interface. The interface may electrically or physically connect the electronic device 101 to an external electronic device, and may include a USB connector, an SD card/MMC connector, or an audio connector. According to an embodiment, the first printed circuit board 250 and the second printed circuit board 252 may be operatively or electrically connected with each other through a connection member (e.g., a flexible printed circuit board).

According to an embodiment, the battery 270 may supply power to at least one component of the electronic device 101. For example, the battery 270 may include a rechargeable secondary battery or a fuel cell. At least a portion of the battery 270 may be disposed on substantially the same plane as the first printed circuit board 250 and/or the second printed circuit board 252.

The electronic device 101 according to an embodiment may include an antenna module (not illustrated). According to an embodiment, the antenna module may be disposed between the rear plate 211 and the battery 270. The antenna module may include, for example, a near field communication (NFC) antenna, a wireless charging antenna, and/or a magnetic secure transmission (MST) antenna. The antenna module may, for example, perform short-range communication with an external device or wirelessly transmit and receive power to and from the external device.

According to an embodiment, the first camera 205 (e.g., a front camera) may be disposed on at least a portion (e.g., the supporting portion 243) of the frame structure 240, so that a lens may receive external light through a partial region (e.g., a camera region 237) of the front plate 202 (e.g., the front surface 200A of FIG. 1).

According to an embodiment, the second camera 212 (e.g., a rear camera) may be disposed between the frame structure 240 and the rear plate 211. According to an embodiment, the second camera 212 may be electrically connected to the first printed circuit board 250 through a connection member (e.g., a connector). According to an embodiment, the second camera 212 may be disposed, so that a lens may receive external light through a camera region 284 of the rear plate 211 of the electronic device 101.

According to an embodiment, the camera region 284 may be formed on a surface (e.g., the rear surface 200B of FIG. 1) of the rear plate 211. According to an embodiment, the camera region 284 may be formed at least partially transparent so that the external light may be incident on the lens of the second camera 212. According to an embodiment, at least a portion of the camera region 284 may protrude from the surface of the rear plate 211 to a predetermined height. However, it is not limited to thereto, and in another embodiment, the camera region 284 may form substantially the same plane as the surface of the rear plate 211.

According to an embodiment, a housing (e.g., the housing 210 of FIG. 2) of the electronic device 101 may mean a configuration or a structure forming at least a portion of an exterior of the electronic device 101. In this regard, at least a portion of the front plate 202, the frame structure 240, and/or the rear plate 211 forming the exterior of the electronic device 101 may be referred to as the housing 210 of the electronic device 101.

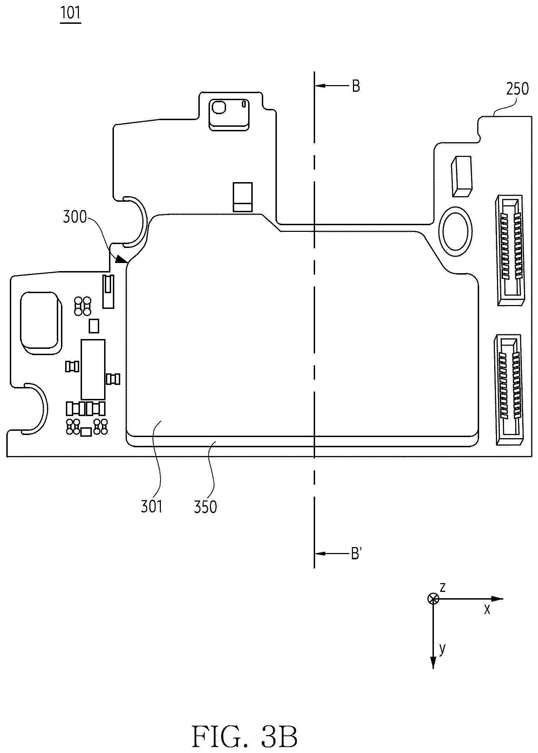

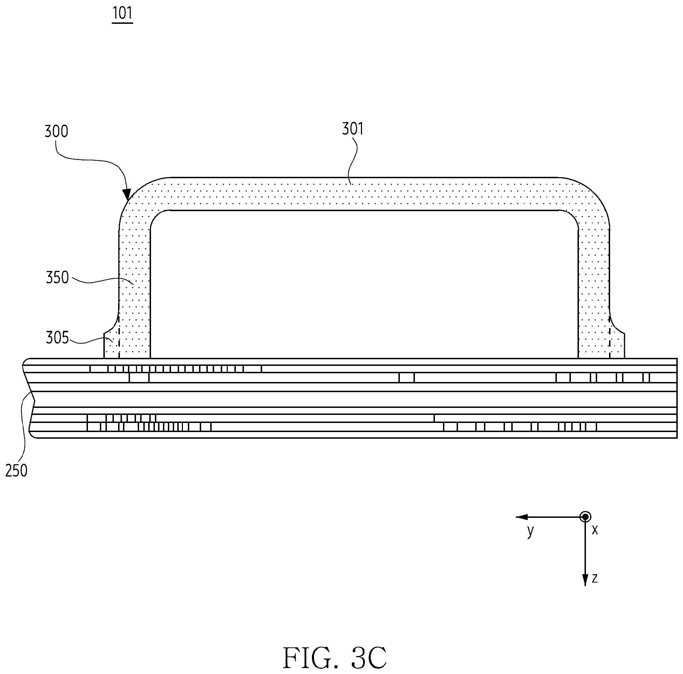

FIG. 3B is an enlarged view of an exemplary electronic device in which a region A of FIG. 3A is enlarged. FIG. 3C is a cross-sectional view of an exemplary electronic device cut along line B-B' of FIG. 3B.

Referring to FIGS. 3B and 3C, an electronic device 101 may include a first printed circuit board 250 and a shield can 300.

According to an embodiment, the first printed circuit board 250 may be disposed in the electronic device 101. The first printed circuit board 250 may include electronic components. For example, a housing (e.g., the housing of FIG. 2) of the electronic device 101 may include a front surface (e.g., the front surface 200A of FIG. 2), a rear surface (e.g., the rear surface 200B of FIG. 2) opposite the front surface 200A, and a side surface (e.g., the side surface 200C of FIG. 2) surrounding a space between the front surface 200A and the rear surface 200B. The housing 210 may include an inner space surrounded by the front surface 200A, the rear surface 200B, and the side surface 200C. The inner space may be a space for accommodating the electronic components of the electronic device 101. The first printed circuit board 250 may be disposed in the inner space. At least a portion of the electronic components may be disposed on the first printed circuit board 250.

According to an embodiment, the shield can 300 may be disposed on the first printed circuit board 250. In this document, when an element is referred to as being "on" another element, it should be understood that it may be directly on the other element or that intervening elements may be present therebetween. For example, in this document, "B disposed on A" may refer to "B in contact with A". For example, in this document, "B disposed on A" may refer to "B faced away from A". For example, "a shield can disposed on a first printed circuit board" may refer to "a shield can in contact with a first printed circuit board". For example, "a shield can disposed on a first printed circuit board" may refer to "a shield can faced away from a first printed circuit board". The shield can 300 may cover at least one electronic component disposed on the first printed circuit board 250.

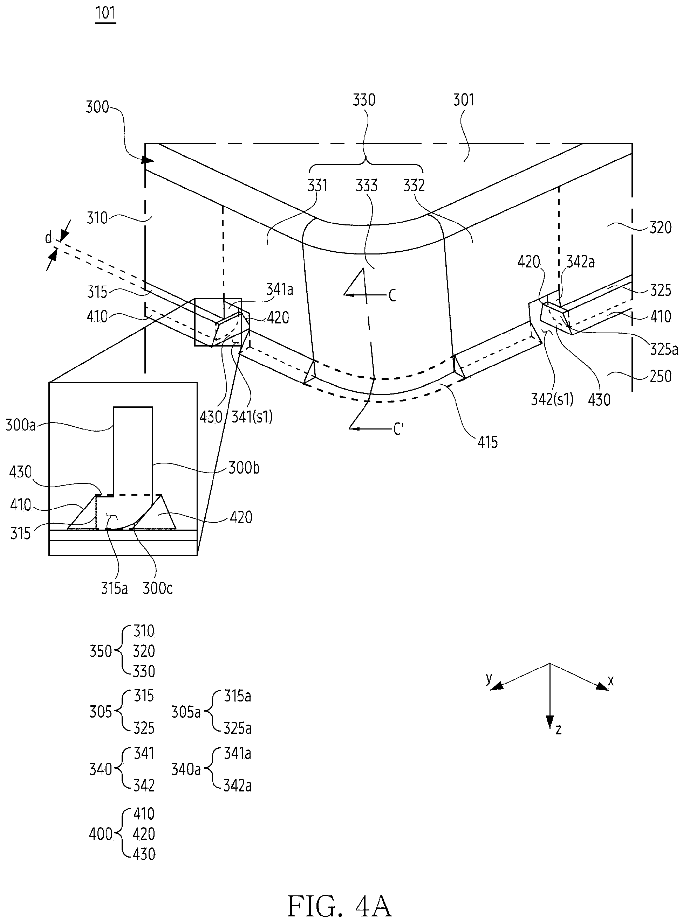

For example, the shield can 300 may be connected to the first printed circuit board 250. For example, the shield can 300 may be coupled with the first printed circuit board 250. For example, the shield can 300 may be attached to the first printed circuit board 250. For example, the shield can 300 may be combined with the first printed circuit board 250 through at least one component (e.g., a solder 400 of FIG. 4A) between the shield can 300 and the first printed circuit board 250.

For example, the shield can 300 may be disposed on a surface of the first printed circuit board 250. The shield can 300 may surround at least one electronic component of the electronic device 101 disposed on the surface of the first printed circuit board 250. For example, as the shield can 300 surrounds the at least one electronic component, the shield can 300 may block an electromagnetic wave generated from the at least one electronic component, or reduce exposure of the at least one electronic component to an electromagnetic wave generated from another electronic component and/or external noise of the shield can 300.

It has been described that the shield can 300 is disposed on the first printed circuit board 250, but it is not limited thereto. The electronic device 101 may include a plurality of printed circuit boards. The shield can 300 may be disposed on another printed circuit board (e.g., the second printed circuit board 252 of FIG. 3A) different from the first printed circuit board 250 disposed in the electronic device 101. The shield can 300 may surround at least one electronic component disposed on the other printed circuit board.

According to an embodiment, the shield can 300 may include a base 301. The base 301 may be faced away from the first printed circuit board 250. For example, the base 301 may be faced away from a surface of the first printed circuit board 250 on which the shield can 300 is disposed. For example, the base 301 may extend in a direction parallel to the first printed circuit board 250. For example, when viewed from above, the base 301 may overlap at least one component surrounded by the shield can 300.

According to an embodiment, the shield can 300 may include a sidewall 350 disposed along a periphery of the base 301. For example, the sidewall 350 may extend from the base 301 toward the first printed circuit board 250. The sidewall 350 may surround at least one electronic component disposed on the first printed circuit board 250. For example, the sidewall 350 may be in contact with the first printed circuit board 250. For example, the sidewall 350 may be welded to the first printed circuit board 250 through a solder (e.g., the solder 400 of FIG. 4A). The sidewall 350 may reduce exposure of the at least one electronic component to an electromagnetic wave generated from another electronic component and/or external noise of the shield can 300, by surrounding the at least one electronic component disposed on the first printed circuit board 250.

According to an embodiment, the sidewall 350 of the shield can 300 may include a flange portion 305 facing the outside of the shield can 300 at a position adjacent to the first printed circuit board 250.

For example, the sidewall 350 may be in contact with the first printed circuit board 250. The flange portion 305 may extend toward the outside of the shield can 300 at a position where the sidewall 350 is in contact with the first printed circuit board 250. The flange portion 305 may be in contact with the first printed circuit board 250.

For example, the flange portion 305 may be disposed along a periphery of the sidewall 350 toward the first printed circuit board 250. The flange portion 305 may be disposed along the periphery adjacent to the first printed circuit board 250 of the sidewall 350. The flange portion 305 may protrude from at least a portion of the side wall 350 toward the outside of the shield can 300. The flange portion 305 may support the shield can 300 by using the first printed circuit board 250, by being disposed at a position adjacent to the first printed circuit board 250 of the side wall 350. The shield can 300 may reduce damage to the sidewall 350 adjacent to the first printed circuit board 250 by an external impact, by including the flange portion 305.

According to an embodiment, the flange portion 305 may be spaced apart from the base 301 of the shield can 300. The flange portion 305 may include a step. For example, the flange portion 305 may be disposed on a portion of the side wall 350 spaced apart from the periphery of the base 301. For example, by protruding from the portion of the side wall 350, the flange portion 305 may include the step formed between a remaining portion excluding the portion of the side wall 350 and the portion of the side wall 305 on which the flange portion 305 is disposed.

According to an embodiment, the electronic device 101 may reduce the exposure of the at least one electronic component to the electromagnetic wave generated from the other electronic component and/or the external noise of the shield can 300 by including the shield can 300 surrounding at least one electronic component disposed on the first printed circuit board 250. The shield can 300 may include the flange portion 305 facing the outside at a position adjacent to the first printed circuit board 250 of the side wall 350, thereby supporting the shield can 300 by using the first printed circuit board 250 and reducing damage to the side wall 350 0.

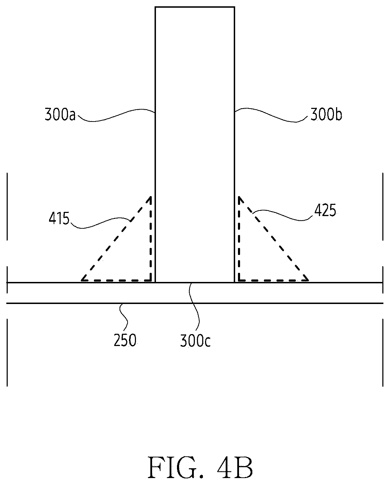

FIG. 4A illustrates a portion of a shield can of an exemplary electronic device. FIG. 4B is a cross-sectional view of a shield can of an electronic device cut along line C-C' of FIG. 4A.

Referring to FIGS. 4A and 4B, an electronic device 101 may include a first printed circuit board 250, a shield can 300, and a solder 400. The shield can 300 may include a base 301 and a sidewall 350.

According to one embodiment, the shield can 300 may include an outer surface 300a, an inner surface 300b opposite the outer surface 300a and surrounding an inner space of the shield can 300, and a bottom surface 300c extending from the outer surface 300a to the inner surface 300b and facing the first printed circuit board 250. The sidewall 350 of the shield can 300 may include the bottom surface 300c. For example, the outer surface 300a may face the outside of the shield can 300a. For example, the inner surface 300b may surround at least one electronic component surrounded by the shield can 300. For example, the bottom surface 300c may face the first printed circuit board 250. The bottom surface 300c may support the shield can 300 by using the first printed circuit board 250 by facing the first printed circuit board 250.

According to an embodiment, the solder 400 may be in contact with the first printed circuit board 250 and the shield can 300 to fasten the shield can 300 to the first printed circuit board 250. For example, the solder 400 may be in contact with the sidewall 350 of the shield can 300.

For example, the shield can 300 may be disposed on a surface of the first printed circuit board 250. The bottom surface 300c of the sidewall 350 may be in contact with the surface of the first printed circuit board 250. The solder 400 may be in contact with a portion of the sidewall 350 including the bottom surface 300c which is in contact with the surface, on the surface of the first printed circuit board 250.

For example, although not illustrated, the solder 400 may be disposed between the first printed circuit board 250 and the sidewall 350. The solder 400 may be in contact with the bottom surface 300c of the sidewall 350 facing the first printed circuit board 250. The solder 400 may reduce separation of the shield can 300 from the first printed circuit board 250 and fasten the shield can 300 on the first printed circuit board 250, by contacting the shield can 300 and the first printed circuit board 250.

According to an embodiment, the solder 400 may be disposed along a periphery of the sidewall 350 adjacent to the first printed circuit board 250. For example, the solder 400 may be disposed along a periphery of the outer surface 300a of the shield can 300 at a position adjacent to the first printed circuit board 250 of the side wall 350. For example, the solder 400 may be disposed along a periphery of the inner surface 300b of the shield can 300 at a position adjacent to the first printed circuit board 250 of the sidewall 350.

According to an embodiment, the sidewall 350 of the shield can 300 may include a first supporting portion 310, a second supporting portion 320, and a connecting portion 330. The first supporting portion 310 and the second supporting portion 320 may support the shield can 300 by using the first printed circuit board 250. The connecting portion 330 may connect the first supporting portion 310 and the second supporting portion 320. The connecting portion 330 may be at least partially bent.

For example, the first supporting portion 310 and the second supporting portion 320 may contact the first printed circuit board 250. The first supporting portion 310 and the second supporting portion 320 may be configured so that the shield can 300 is supported on a surface of the first printed circuit board 250 by contacting the first printed circuit board 250. For example, the first supporting portion 310 and the second supporting portion 320 may be fastened on the first printed circuit board 250 through the solder 400 in contact with the first printed circuit board 250. The first supporting portion 310 and the second supporting portion 320 may be fastened on the first printed circuit board 250 so that the shield can 300 is supported on the surface of the first printed circuit board 250.

For example, the connecting portion 330 may extend from the first supporting portion 310 to the second supporting portion 320. At least a portion of the connecting portion 330 may be bent to connect the first supporting portion 310 and the second supporting portion 320.

It has been described that the first supporting portion 310 and the second supporting portion 320 support the shield can 300 on a surface of the first printed circuit board 250, but it is not limited thereto. The connecting portion 330 connecting the first supporting portion 310 and the second supporting portion 320 may support the shield can 300 on a surface of the first printed circuit board 250. For example, at least a portion of the connecting portion 330 may be in contact with the first printed circuit board 250. The connecting portion 330 may be configured so that the shield can 300 is fastened to the first printed circuit board 250, through the at least portion of the connecting portion 330 in contact with the first printed circuit board 250. For example, the at least a portion of the connecting portion 330 may be fastened on the first printed circuit board 250, through the solder 400 in contact with the first printed circuit board 250. The at least a portion of the connecting portion 330 may be configured so that the shield can 300 is supported by the first printed circuit board 250 through the solder 400.

According to an embodiment, each of the first supporting portion 310 and the second supporting portion 320 of the sidewall 350 may include a flange portion 305 facing the outside of the shield can 300 at a position adjacent to the first printed circuit board 250. For example, the flange portion 305 may include a first flange portion 315 disposed in the first supporting portion 310 and a second flange portion 325 disposed in the second supporting portion 320.

For example, the flange portion 305 may be a portion extending toward the outside of the shield can 300 at a position adjacent to the first printed circuit board 250 of the first supporting portion 310 and the second supporting portion 320. For example, the flange portion 305 may be a portion bent toward the outside of the shield can 300 at a position adjacent to the first printed circuit board 250 of the first supporting portion 310 and the second supporting portion 320. For example, each of the first supporting portion 310 and the second supporting portion 320 may contact the first printed circuit board through the flange portion 305. For example, each of the first supporting portion 310 and the second supporting portion 320 may be fastened to the first printed circuit board 250 through the flange portion 305.

For example, the flange portion 305 may be a portion where the first supporting portion 310 and the second supporting portion 320 are in contact with the solder 400 and/or the first printed circuit board 250.

For example, the flange portion 305 may protrude from the outer surface 300a of the shield can 300 toward the outside of the shield can 300. For example, the flange portion 305 may include a portion bent toward the outside of the shield can 300 at a position adjacent to the first printed circuit board 250 of the first supporting portion 310 and the second supporting portion 320. The bent portion may include the bottom surface 300c of the shield can 300 included in the first supporting portion 310 and the second supporting portion 320. The bottom surface 300c included in the first supporting portion 310 and the second supporting portion 320 may be bent to face the first printed circuit board 250. The shield can 300 may increase an area of the bottom surface 300c supported by the first printed circuit board 250 by including the bottom surface 300c in which the flange portion 305 is bent. As the shield can 300 includes the flange portion 305 including the bent bottom surface, the shield can 300 may increase an area of the sidewall 350 in contact with the solder 400 at a position adjacent to the first printed circuit board 250.

For example, a direction in which the first supporting portion 310 extends may be different from a direction in which the second supporting portion 320 extends. A direction in which the first flange portion 315 included in the first supporting portion 310 faces may be different from a direction in which the second flange portion 325 included in the second supporting portion 320 faces. Since the direction in which the first flange portion 315 faces and the direction in which the second flange portion 325 faces are different, the first flange portion 315 and the second flange portion 325 may support the shield can 300 by using the first printed circuit board 250.

According to an embodiment, a length d of the flange portion 305 extending from the sidewall 350 toward the outside of the shield can 300 may be located within a range of about 0.05 mm or more and about 0.1 mm or less. As the length d is located within the range of about 0.05 mm or more and about 0.1 mm or less, the shield can 300 may reduce damage to a portion including the flange portion 305 adjacent to the first printed circuit board 250 from an external impact.

According to an embodiment, the flange portion 305 may include a curvature that is bent from the inner surface 300b of the shield can 300. For example, the flange portion 305 included in each of the first supporting portion 310 and the second supporting portion 320 may include the bottom surface 300c extending from the inner surface 300a included in the sidewall 350 of the shield can 300 to the outer surface 300b included in the sidewall 350 of the shield can 300. The bottom surface 300c may be a surface facing the first printed circuit board 250 of the sidewall 350. The flange portion 305 may be a portion of the sidewall 350 adjacent to the first printed circuit board 250, that is at least partially surrounded by the outer surface 300a included in the sidewall 350 and the bottom surface 300c. As the flange portion 305 includes the curvature, the shield can 300 may reduce damage to the portion including the flange portion 305 adjacent to the first printed circuit board 250 from an external impact.

According to an embodiment, the connecting portion 330 of the sidewall 350 may have a planar shape at a position adjacent to the first printed circuit board 250. For example, the connecting portion 330 may not include the flange portion 305 facing the outside of the shield can 300, unlike the first supporting portion 310 and the second supporting portion 320 at a position adjacent to the first printed circuit board 250.

For example, the outer surface 300a included in the connecting portion 330 may be included in the connecting portion 330 at a position adjacent to the first printed circuit board 250 and connected in a planar shape to the bottom surface 300c facing the first printed circuit board 250. For example, the outer surface 300a included in the connecting portion 330 may not include a step due to the flange portion 305 facing the outside of the shield can 300 at a position adjacent to the first printed circuit board 350, unlike the outer surface 300a included in the first supporting portion 310 and the second supporting portion 320. For example, the inner surface 300b included in the connecting portion 330 may be parallel to the outer surface 300a that does not include the step included in the connecting portion 330 at a position adjacent to the first printed circuit board 250, unlike the inner surface 300b included in the first supporting portion 310 and the second supporting portion 320. For example, at least a portion of the outer surface 300a may extend from the bottom surface 300c. The at least a portion of the outer surface 300a may be substantially perpendicular to the bottom surface 300c.

For example, the connecting portion 330 having a planar shape at a position adjacent to the first printed circuit board 250 may contact the solder 400 at the position adjacent to the first printed circuit board 250. As the connecting portion 330 that is at least partially bent has a planar shape at the position adjacent to the first printed circuit board 250, each of the outer surface 300a included in the connecting portion 330 and the inner surface 300b included in the connecting portion 330 may be supported with substantially the same magnitude of force by the first printed circuit board 250 and/or the solder 400.

For example, unlike the bottom surface 300c included in the first supporting portion 310 and the second supporting portion 320, the bottom surface 300c included in the connecting portion 330 may not include a curvature or a curved surface. For example, the bottom surface 300c included in the connecting portion 330 may be parallel to the first printed circuit board 250. Unlike the first supporting portion 310 including the first flange portion 315 and the second support portion 320 including the second flange portion 325, as the connecting portion 330 that is at least partially bent by connecting the first supporting portion 310 and the second supporting portion 320 has a planar shape at a position adjacent to the first printed circuit board 250, the connecting portion 330 may reduce peeling of the connecting portion 330 from the solder 400 contacted with the connecting portion 330 due to an external impact. As the connecting portion 330 has a planar shape at the position adjacent to the first printed circuit board 250, the connecting portion 330 may be configured to provide an additional space for electronic components disposed on the first printed circuit board 250 around the connecting portion 330.

According to an embodiment, the connecting portion 330 of the side wall 350 may have a planar shape at a position adjacent to the flange portion 305. For example, the connecting portion 330 may have a planar shape at a position adjacent to the first flange portion 315 of the first supporting portion 310 and the second flange portion 325 of the second supporting portion 320. A portion of the connecting portion 330 having a planar shape may be disposed between the first flange portion 315 and the second flange portion 325.

According to an embodiment, the connecting portion 330 of the sidewall 350 may be perpendicular to the first printed circuit board 250. For example, the bottom surface 300c included in the connecting portion 330 may contact the first printed circuit board 250. Each of the outer surface 300a and the inner surface 300b included in the connecting portion 330 may extend in a direction substantially perpendicular to the first printed circuit board 250 from the bottom surface 300c included in the connecting portion 330. As the connecting portion 330 is perpendicular to the first printed circuit board 250, the connecting portion 330 at least partially bent may be configured to reduce peeling of the connecting portion 330 from the solder 400 in contact with the connecting portion 330 at a position adjacent to the first printed circuit board 250, and provide the additional space for the electronic components disposed on the first printed circuit board 250 around the connecting portion 330 at the position adjacent to the first printed circuit board 250.

According to an embodiment, the connecting portion 330 of the sidewall 350 may include at least one groove 340 at a position adjacent to the first printed circuit board 250 and the flange portion 305. The at least one groove 340 may extend from the outer surface 300a of the shield can 300 to the inner surface 300b of the shield can 300. For example, the solder 400 may be in contact with an inner surface 340a of the at least one groove 340.

For example, the at least one groove 340 may be disposed in a portion of the bottom surface 300c included in the connecting portion 330 adjacent to the first supporting portion 310 and/or the second supporting portion 320. For example, the at least one groove 340 may be in contact with a boundary between the connecting portion 330 and the first supporting portion 310 and/or a boundary between the connecting portion 330 and the second supporting portion 320. For example, a portion of the at least one groove 340 may include a shape of the flange portion 305 included in the first supporting portion 310 and/or the second supporting portion 320, and a remaining portion of the at least one groove 340 may include a planar shape of the connecting portion 330. For example, a portion of the inner surface 340a of the at least one groove 340 may include a side surface 305a of the flange portion 305. For example, the portion of the inner surface 340a of the at least one groove 340 may face the first printed circuit board 250.

For example, the inner surface 340a of the at least one groove 340 may extend from the outer surface 300a of the shield can 300 to the inner surface 300b of the shield can 300. For example, at least a portion of the inner surface 340a of the at least one groove 340 may be in contact with the solder 400 in contact with the first printed circuit board 250 at a position adjacent to the first printed circuit board 250 of the connecting portion 330 including the at least one groove 340. For example, a portion of the inner surface 340a of the at least one groove 340 that includes the shape of the flange portion 305 may be in contact with the solder 400. A portion of the inner surface 340a of the at least one groove 340 that includes the shape of the connecting portion 330 may be in contact with the solder 400. As the inner surface 340a of the at least one groove 340 is in contact with the solder 400, the at least one groove 340 may increase an area in which the shield can 300 is in contact with the solder 400 and may reduce peeling of the shield can 300 from the solder 400 and/or the first printed circuit board 250 in contact with the solder 400.

According to an embodiment, a size s1 of the at least one groove 340 may be located within a range of about 0.04 mm² or more and about 0.09 mm² or less. As the size s1 of the at least one groove 340 is located within the range of about 0.04 mm² or more and about 0.09 mm² or less, the at least one groove 340 may reduce exposure of at least one electronic component surrounded by the shield can 300 to an electromagnetic wave generated from another electronic component disposed outside the shield can 300 and/or external noise of the shield can 300.

According to an embodiment, the solder 400 may include a first region 410, a second region 420, and a third region 430 disposed along a periphery adjacent to the first printed circuit board 250 of the sidewall 350. The first region 410 may be in contact with the outer surface 300a of the shield can 300. The second region 420 may be in contact with the inner surface 300b of the shield can 300. The third region 430 may be in contact with the inner surface 340a of the at least one groove 340 and extend from the first region 410 to the second region 420.

For example, the first region 410 may be disposed along a periphery of the outer surface 300a of the shield can 300 at a position adjacent to the first printed circuit board 250 of the side wall 350. At least a portion of the first region 410 may be in contact with the flange portion 305 facing the outside of the shield can 300. For example, the second region 420 may be disposed along a periphery of the inner surface 300b of the shield can 300 at a position adjacent to the first printed circuit board 250 of the sidewall 350. For example, the first support portion 310 and the second support portion 320 may include the bent bottom surface 300c extending from the inner surface 300b and facing the first printed circuit board 250 to include the flange portion 305. At least a portion of the second region 420 of the solder 400 may be in contact with the bent bottom surface 300c included in the first support portion 310 and the second support portion 320. For example, the first region 410 may be disposed along the periphery of the outer surface 300a having a planar shape included in the connecting portion 330 at a position adjacent to the first printed circuit board 250 of the connecting portion 330. The second region 420 may be disposed along the periphery of the inner surface 300b having a planar shape included in the connecting portion 330 at the position adjacent to the first printed circuit board 250 of the connecting portion 330.

For example, the third region 430 may connect the first region 410 and the second region 420 by contacting the inner surface 340a of the at least one groove 340. For example, the third region 430 may be in contact with a portion of the inner surface 340a of the at least one groove 340 that includes the side surface 305a of the flange portion 305. For example, the third region 430 may be in contact with a portion of the inner surface 340a of the at least one groove 340 that includes a planar shape of the connecting portion 330 at a position adjacent to the first printed circuit board 250. The solder 400 may reduce peeling of the shield can 300 in contact with the solder 400, from the solder 400 due to an external impact by including the third region 430. The solder 400 may reduce separation of the shield can 300 in contact with the solder 400 from the first printed circuit board 250 by including the third region 430.

According to an embodiment, the at least one groove 340 may include a first groove 341 and/or a second groove 342. The first groove 341 may be formed in a portion of the connecting portion 330 in contact with the first supporting portion 310. The second groove 342 may be formed in a remaining portion of the connecting portion 330 in contact with the second supporting portion 320. For example, the first groove 341 may be in contact with a boundary between the first supporting portion 310 and the connecting portion 330 at a position adjacent to the first printed circuit board 250 of the side wall 350. An inner surface 341a of the first groove 341 may include a side surface 315a of the first flange portion 315 included in the first supporting portion 310. For example, the second groove 342 may be in contact with a boundary between the second supporting portion 320 and the connecting portion 330 at a position adjacent to the first printed circuit board 250 of the side wall 350. An inner surface 342a of the second groove 342 may include a side surface 325a of the second flange portion 325 included in the second supporting portion 320.

It has been described that the shield can 300 includes the first groove 341 and the second groove 342, but it is not limited thereto. The shield can 300 may include a plurality of supporting portions spaced apart from each other and a plurality of connecting portions that connect the plurality of supporting portions to each other and are at least partially bent. The shield can 300 may include a plurality of grooves formed at positions adjacent to each of the plurality of connecting portions, the first printed circuit board 250, and each of the plurality of supporting portions. The shield can 300 may include the plurality of grooves, thereby increasing an area in which the shield can 300 is in contact with the solder 400 and reducing the peeling of the shield can 300 from the solder 400 or the separation of the shield can 300 from the first printed circuit board 250.

According to an embodiment, the first supporting portion 310 may extend in a first direction (e.g., a +x direction) toward the connecting portion 330. The second supporting portion 320 may extend in a second direction (e.g., a +y direction) different from the first direction toward the connecting portion 330. For example, the connecting portion 330 may include a first portion 331, a second portion 332, and/or a third portion 333. The first portion 331 may extend from the first supporting portion 310 in the first direction. The second portion 332 may extend from the second supporting portion 320 in the second direction. The third portion 333 may connect the first portion 331 and the second portion 332, and may be bent.

For example, the first portion 331 of the connecting portion 330 may be a portion of the connecting portion 330 in contact with the first supporting portion 310. For example, the first portion 331 may include the first groove 341 at a position adjacent to the first supporting portion 310 and the first printed circuit board 250. For example, the second portion 332 of the connecting portion 330 may be a portion of the connecting portion 330 in contact with the second supporting portion 320. For example, the second portion 332 may include the second groove 342 at a position adjacent to the second supporting portion 320 and the first printed circuit board 250.

For example, the first portion 331 may extend from the first supporting portion 310 in the first direction (e.g., the +x direction) in which the first supporting portion 310 extends toward the connecting portion 330. For example, the second portion 332 may extend from the second supporting portion 320 in the second direction (e.g., the +y direction) in which the second supporting portion 320 extends toward the connecting portion 330. Since the first direction and the second direction are different, the third portion 333 connecting the first portion 331 and the second portion 332 may be bent. As the first portion 331 extending from the first supporting portion 310 and the second portion 332 extending from the second supporting portion 320 have a planar shape at a position adjacent to the first printed circuit board 250, the shield can 300 may reduce peeling of the connecting portion 330 from the solder 400 in contact with the connecting portion 330 due to an external impact. As the bent third portion 333 has a planar shape at a position adjacent to the first printed circuit board 250, each of the outer surface 300a included in the third portion 333 and the inner surface 300b included in the third portion 333 may be supported with substantially the same magnitude of force by the first printed circuit board 250 and/or the solder 400.

According to an embodiment, the solder 400 may be in contact with the first portion 331, and the second portion 332 from among the first portion 331, the second portion 332, and the third portion 333 at a position where the connection portion 330 of the side wall 350 is adjacent to the first printed circuit board 250. The third portion 333 of the connecting portion 330 may be in contact with the first printed circuit board 250.

For example, the first region 410 of the solder 400 may be disposed along the periphery of the outer surface 300a included in the first portion 331 and the second portion 332 at a position adjacent to the first printed circuit board 250 of the connecting portion 330. For example, the second region 420 of the solder 400 may be disposed along the periphery of the inner surface 300b included in the first portion 331 and the second portion 332 at a position adjacent to the first printed circuit board 250 of the connecting portion 330. For example, the third portion 333 may not be in contact with the solder 400. For example, the bottom surface 300c included in the third portion 333 and facing the first printed circuit board 250 may be in contact with the first printed circuit board 250.As the solder 400 is not in contact with the third portion 333, the solder 400 may reduce a force transferred from the solder 400 to the third portion 333 due to an external impact. The third portion 333 is in contact with the first printed circuit board 250, thereby reducing the exposure of the at least one electronic component surrounded by the shield can 300 to the electromagnetic wave generated from the other electronic component disposed outside the shield can 300 and/or the external noise of the shield can 300.

According to an embodiment, the solder 400 may further include a curved region in which the connecting portion 330 of the side wall 350 is disposed along a periphery of the third portion 333 and is in contact with the third portion 333 at a position adjacent to the first printed circuit board 250. For example, the first region 410 of the solder 400 may include a curved region 415 in which the connecting portion 330 is disposed along the periphery of the outer surface 300a included in the third portion 333 at a position adjacent to the first printed circuit board 250. For example, the second region 420 of the solder 400 may include a curved region 425 in which the connecting portion 330 is disposed along the periphery of the inner surface 300b included in the third portion 333 at a position adjacent to the first printed circuit board 250. As the solder 400 includes the region 415 and/or the region 425, the solder 400 may reduce peeling of the bent third portion 333 of the connecting portion 330 from the solder 400 in contact with the third portion 333, and reduce separation of the third portion 333 from the first printed circuit board 250.

According to an embodiment, the shield can 300 may connect the first supporting portion 310 and the second portion 320 extending in different directions by including the connecting portion 330 that is at least a partially bent. As the connecting portion 330 has a planar shape without the flange portion 305 at a position adjacent to the first printed circuit board 250, each of the outer surface 300a included in the connecting portion 330 and the inner surface 300b included in the connecting portion 330 may be supported by the first printed circuit board 250 and/or the solder 400 with substantially the same magnitude of force. As the connecting portion 330 has a planar shape without the flange portion 305 at the position adjacent to the first printed circuit board 250, the connecting portion 330 may reduce the peeling of the connecting portion 330 from the solder 400 in contact with the connecting portion 330 due to an external impact. As the connecting portion 330 has a planar shape without the flange portion 305 at the position adjacent to the first printed circuit board 250, the connecting portion 330 may be configured to provide the additional space for the electronic components disposed on the first printed circuit board 250 around the connecting portion 330. The connecting portion 330 may increase the area in which the shield can 300 is in contact with the solder 400 and reduce the peeling of the shield can 300 from the solder 400, by including the at least one groove 340. The solder 400 may increase the area in contact with the shield can 300 and reduce the separation of the shield can 300 from the first printed circuit board 250, by including the third region 430 in contact with the inner surface 340a of the at least one groove 340.

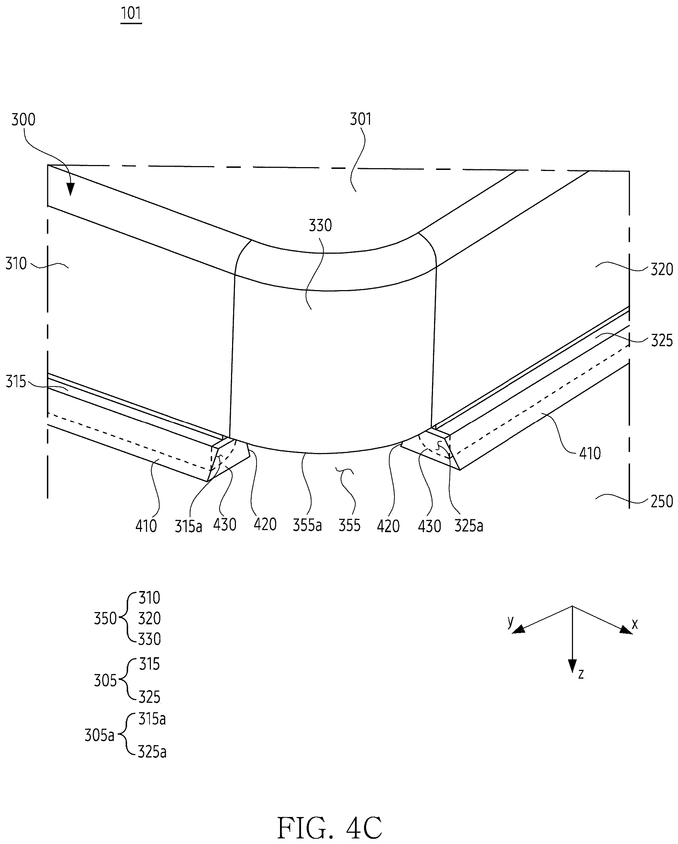

FIG. 4C illustrates a portion of a shield can of an exemplary electronic device.

Referring to FIG. 4C, an electronic device 101 may include a first printed circuit board 250, a shield can 300, and a solder 400. The shield can 300 may include a base 301 and a sidewall 350. The sidewall 350 may include a first supporting portion 310, a second supporting portion 320, and a connecting portion 330. Each of the first supporting portion 310 and the second supporting portion 320 may include a flange portion 305.

Hereinafter, overlapping descriptions of the configuration described in FIGS. 4A and 4B will be omitted.

According to an embodiment, the sidewall 350 may further include a slit 355 that is surrounded by the connecting portion 330, the first supporting portion 310, and the second supporting portion 320 at a position adjacent to the printed circuit board 250. For example, the slit 355 may be understood as recesses formed in the connecting portion 330. The slit 355 may extend from an outer surface 300a of the shield can 300 to an inner surface 300b of the shield can 300b. Referring to FIGS. 4A and 4B, the slit 355 may be understood as a groove formed in a bent third portion 333 of the connecting portion 330.

For example, the slit 355 may contact the first supporting portion 310 and the second supporting portion 320 at a position where the connecting portion 330 of the side wall 350 is adjacent to the first printed circuit board 250. For example, a portion of an inner surface 355a of the slit 355 that faces the first printed circuit board 250 may be a bottom surface (e.g., the bottom surface 300c of FIG. 4A) of the shield can 300 included in the connecting portion 330. For example, as the shield can 300 included in the connecting portion 330 faced away from the first printed circuit board 250, the connecting portion 330 may be spaced away from the first printed circuit board 240. As the connecting portion 330 is spaced apart from the first printed circuit board 250, the connecting portion 330 may be configured to form the slit 355 together with the first supporting portion 310 and the second supporting portion 320 connected to the connecting portion 330. For example, the slit 355 may be an opening surrounded by the connecting portion 330, a first flange portion 315 included in the first supporting portion 310, a second flange portion 325 included in the second supporting portion 320, and the first printed circuit board 250. By including the slit 355, the shield can 300 may reduce a force transferred from the first printed circuit board 250 to the connecting portion 330 of the sidewall 350 due to an external impact.

According to an embodiment, the inner surface 355a of the slit 355 may include a side surface 305a of the flange portion 305. For example, the inner surface 355a of the slit 355 may include a side surface 315a of the first flange portion 315 included in the first supporting portion 310. The inner surface 355a of the slit 355 may include a side surface 325a of the second flange portion 325 included in the second supporting portion 320. The slit 355 may include a bottom surface 300c of the connecting portion 330 in contact with the side surface 315a of the first flange portion 315 and the side surface 325a of the second flange portion 325 and faced away from the first printed circuit board 250. The slit 355 may be understood as a space surrounded by the side surface 315a of the first flange portion 315, the side surface 325a of the second flange portion 325, the bottom surface 300c included in the connecting portion 330, and the first printed circuit board 250. As the inner surface 355a of the slit 355 includes the side surface 305a of the flange portion 305, the slit 355 may increase an area in which the solder 400 in contact with the shield can 300 is in contact with the shield can 300. By increasing the area in which the shield can 300 is in contact with the solder 400, the slit 355 may reduce peeling of the shield can 300 from the solder 400 or separation from the first printed circuit board 250 due to an external impact.

According to an embodiment, the solder 400 may include a first region 410, a second region 420, and a third region 430 disposed along a periphery adjacent to the first printed circuit board 250 of the sidewall 350. The first region 410 may be in contact with the outer surface 300a of the shield can 300. The second region 420 may be in contact with the inner surface 300b of the shield can 300. The third region 430 may be in contact with the inner surface 355a of the slit 355 and extend from the first region 410 to the second region 420. For example, the solder 400 may be in contact with the flange portion 305 included in each of the first supporting portion 310 and the second supporting portion 320. The first region 410 of the solder 400 may be in contact with the outer surface 300a of the shield can 300 included in the flange portion 305. The second region 420 of the solder 400 may be in contact with the inner surface 300b of the shield can 300 included in the flange portion 305. The third region 430 of the solder 400 may extend from the first region 410 to the second region 420 by contacting the side surface 305a of the flange portion 305 included in the inner surface 355a of the slit 355. By including the third region 430 in contact with the inner surface 355a of the slit 355, the solder 400 may increase an area in contact with the shield can 300 and reduce the separation of the shield can 300 from the first printed circuit board 250.

According to the above-described embodiment, the shield can 300 may include the slit 355, thereby increasing an area in which the solder 400 in contact with the shield can 300 contacts the shield can 400, and reducing the separation of the shield can 300 from the first printed circuit board 250. By including the third region 430 in contact with the inner surface 355a of the slit 355, the solder 400 may increase the area in contact with the shield can 300 and reduce the separation of the shield can 300 from the first printed circuit board 250.

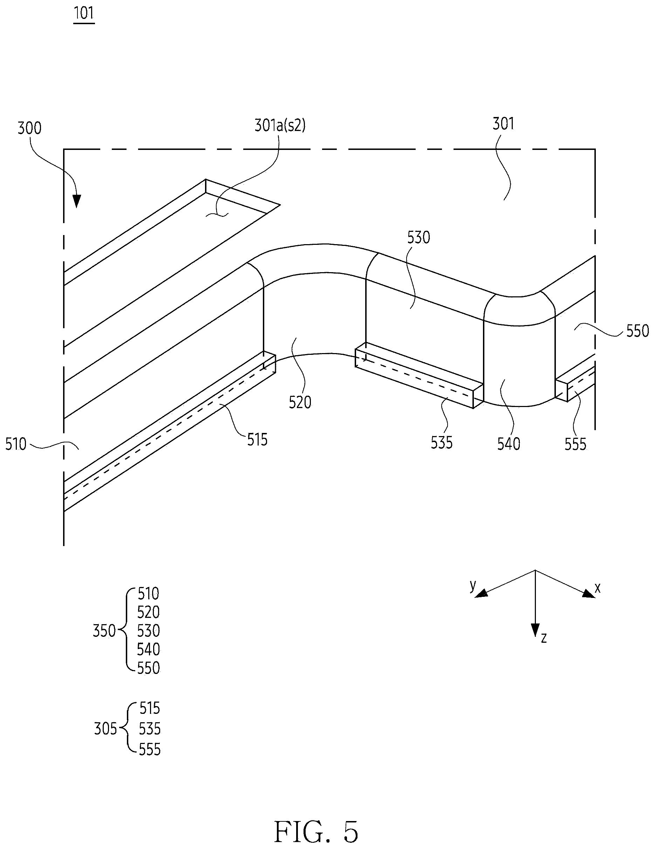

FIG. 5 illustrates a portion of a shield can of an exemplary electronic device.

Referring to FIG. 5, an electronic device 101 may include a first printed circuit board 250 and a shield can 300. For example, the shield can 300 may include a base 301 and a sidewall 350.

According to an embodiment, the base 301 may include a through hole 301a penetrating the base 301. For example, the through hole 301a may extend from an outer surface (e.g., the outer surface 300a of FIG. 4A) of the shield can 300 included in the base 301 to an inner surface (e.g., the inner surface 300b of FIG. 4A) of the shield can included in the base 301. For example, the through hole 301a may expose at least a portion of at least one electronic component surrounded by the shield can 300 to the outside of the shield can 300. For example, the through hole 301a may be a path for connecting the at least one electronic component surrounded by the shield can 300 and another electronic component disposed outside the shield can 300.

According to an embodiment, a size s2 of the through hole 301a may be located within a range of about 0.29mm² or more and about 0.51mm² or less. For example, the size s2 of the through hole 301a may be larger than the size s1 of the at least one groove 340 of FIG. 4A.

According to an embodiment, the sidewall 350 may include connect supporting portions 510, 530, and 550 (e.g., the first supporting portion 310 and the second supporting portion 320 of FIG. 4A), and connecting portions 520, and 540 (e.g., the connecting portion 330 of FIG. 4A), connecting each of the supporting portions 510, 530, and 550 and being at least partially bent. Each of the supporting portions 510, 530, and 550 may include a flange portion 305 facing the outside of the shield can 300 at a position adjacent to the first printed circuit board 250 of the sidewall 350.

For example, a first connecting portion 520 may extend from a third supporting portion 510 including a third flange portion 515 to a fourth supporting portion 530 including a fourth flange portion 535. The first connecting portion 520 may be at least partially bent toward the inside of the shield can 300 as directions in which the third supporting portion 510 and the fourth supporting portion 530 extend are different. For example, a second connecting portion 540 may extend from the fourth supporting portion 530 including the fourth flange portion 535 to a fifth supporting portion 550 including a fifth flange portion 555. The second connecting portion 540 may be at least partially bent toward the outside of the shield can 300 as directions in which the fourth supporting portion 530 and the fifth supporting portion 550 extend are different. Each of the connecting portions 520 and 540 may have a planar shape at a position adjacent to the first printed circuit board 250 of the sidewall 350. For example, each of the connecting portions 520 and 540 may not include the flange portion 305.

It has been described that the shield can 300 includes the supporting portions 510, 530, and 550 and the connecting portions 520 and 540, but it is not limited thereto. The shield can 300 may include a plurality of supporting portions each including the flange portion 305, and a plurality of connecting portions connecting each of the plurality of supporting portions and being at least partially bent. Each of the plurality of supporting portions includes the flange portion 305, thereby supporting the shield can 300 using the first printed circuit board 250 and reducing damage to the sidewall 350 adjacent to the first printed circuit board 250 due to an external impact. Each of the plurality of connecting portions has a planar shape at a position where the side wall 350 is adjacent to the first printed circuit board 250, thereby reducing peeling of the connecting portions from a solder (e.g., the solder 400 of FIG. 4A) in contact with the plurality of connecting portions having a planar shape and the first printed circuit board 250 due to the external impact.

According to the above-described embodiment, the shield can 300 may include the through hole 301a, thereby providing a path through which at least one electronic component surrounded by the shield can 300 may be connected to another electronic device outside the shield can 300. The shield can 300 may include the supporting portions 510, 530, and 550 respectively including the flange portion 305, and the connecting portions 520, 540 respectively connecting the supporting portions 510, 530, and 550 and being at least partially bent, thereby reducing damage to the sidewall 350 of the shield can 300 and reducing the shield can 300 from being separated from the first printed circuit board 250.

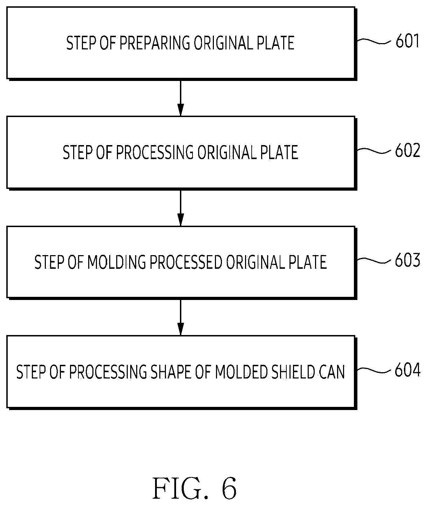

FIG. 6 is a flow chart illustrating a manufacturing process of an exemplary shield can.

In a process 601, an original plate of a shield can (e.g., the shield can 300 of FIG. 3B) may be prepared for manufacture of the shield can 300. For example, in the process 601, a mold of substantially the same size as a shape of the shield can 300 may be prepared. The original plate of the shield can 300 may be provided in a size in which at least a portion of the original plate may cover the mold when the original plate is pressed on the mold.

In a process 602, the original plate of the shield can 300 may be processed. For example, in the process 602, at least a portion of a periphery of the original plate of the shield can 300 may be removed for a shape of connecting portions (e.g., the connecting portion 330 of FIG. 4A, the connecting portions 520 and 540 of FIG. 5) of the shield can 300. Portions of the original plate in contact with the at least portion may be portions that are bent when the original plate is pressed on the mold.

In a process 603, the original plate of the processed shield can 300 may be molded. For example, in the process 603, the original plate of the shield can 300 may be pressed on the mold. As the original plate is pressed on the mold, a base (e.g., the base 301 of FIG. 3C) of the shield can 300 and a sidewall (e.g., the sidewall 350 of FIG. 3C) disposed along a periphery of the base 301 may be formed by a shape of the mold.

In a process 604, a shape of the molded shield can 300 may be processed. For example, in the process 604, a remaining portion of the original plate extending from a portion of the original plate formed in the shape of the shield can 300 may be removed from the portion of the original plate. While the remaining portion of the original plate is removed from the portion of the original plate having the shape of the shield can 300, a flange portion (e.g., the flange portion 305 of FIG. 3C) facing the outside of the shield can 300 may be formed. Through at least a portion of the periphery of the original plate of the shield can 300 that was removed in the process 602, the portions, which were in contact with the removed at least a portion of the original plate, may be configured to have a planar shape unlike the portion including the flange portion 305. The portions including the flange portion 305 may include supporting portions (e.g., the first supporting portion 310, the second supporting portion 320, and the supporting portions 510, 530, and 550 of FIG. 5) of the shield can 300. Portions not including the flange portion 305 may include connecting portions (e.g., connecting portion 330 of FIG. 4A or connecting portions 520 and 540 of FIG. 5) of the shield can 300.

According to the above-described embodiment, the shield can 300 may be processed to form the supporting portions including the flange portion 305 and the connecting portions that are at least partially bent without including the flange portion 305 unlike the supporting portions, thereby reducing peeling of the shield can 300 from a solder (e.g., the solder 400 of FIG. 4A) in contact with the shield can 300 or separation from the printed circuit board (e.g., the first printed circuit board 250 of FIG. 3A and the second printed circuit board 252).

According to the above-described embodiment, an electronic device (e.g., the electronic device 101 of FIG. 1) may comprise a printed circuit board (e.g., the first printed circuit board 250 of FIG. 3A), a shield can (e.g., the shield can 300 of FIG. 3B) disposed on the printed circuit board, and a solder (e.g., the solder 400 of FIG. 4A) in contact with the printed circuit board and the shield can to fasten the shield can to the printed circuit board. The shield can may include a base (e.g., the base 301 of FIG. 3B) faced away from the printed circuit board and a sidewall (e.g., the sidewall 350 of FIG. 3B) disposed along a periphery of the base. The sidewall may include including a first supporting portion (e.g., the first supporting portion 310 of FIG. 4A), a second supporting portion (e.g., the second supporting portion 320 of FIG. 4A), and a connecting portion (e.g., the connecting portion 330 of FIG. 4A) that connects the first supporting portion and the second supporting portion and is at least partially bent, the first supporting portion and the second supporting portion are for supporting the shield can using the printed circuit board. Each of the first supporting portion and the second supporting portion may include a flange portion (e.g., the flange portion 305, the first flange portion 315, and the second flange portion 325 of FIG. 4A) facing an outside of the shield can at a position adjacent to the printed circuit board. The connecting portion may have a planar shape at a position adjacent to the printed circuit board. According to the above-mentioned embodiment, the shield can may include the flange portion thereby reducing damage to the sidewall due to an external impact and supporting the shield can by using the printed circuit board. As the connecting portion, which is at least partially bent, has a planar shape at the position adjacent to the printed circuit board, the shield can may reduce peeling of the shield can in contact with the solder from the solder and may reduce separation of the shield can from the printed circuit board. The above-mentioned embodiment may have various effects including the above-mentioned effect.

According to an embodiment, the connecting portion may include at least one groove (e.g., the at least one groove 340 of FIG. 4A) connected from an outer surface (e.g., the outer surface 300a of FIG. 4A) of the shield can 300 to an inner surface (e.g., the inner surface 300b of FIG. 4A) of the shield can at a position adjacent to the printed circuit board and the flange portion. The solder may be in contact with an inner surface (e.g., the inner surface 340a of the at least one groove of FIG. 4A) of the at least one groove. According to the above-mentioned embodiment, the shield can may include the at least one groove, thereby increasing an area in contact with the solder and reducing peeling of the shield can from the solder. The solder may be in contact with the inner surface of the at least one groove, thereby reducing peeling of the shield can from the printed circuit board. The above-mentioned embodiment may have various effects including the above-mentioned effect.

According to an embodiment, the solder may include a first region (e.g., the first region 410 of FIG. 4A), disposed along a periphery of the sidewall adjacent to the printed circuit board, contacting the outer surface of the shield can, a second region (e.g., the second region 420 of FIG. 4A) contacting the inner surface of the shield can, and a third region (the third region 430 of FIG. 4A), contacting the inner surface of the at least one groove, extending from the first region to the second region. According to the above-mentioned embodiment, the solder may include the third region, thereby increasing an area in contact with the shield can and reducing separation of the shield can from the printed circuit board. The above-mentioned embodiment may have various effects including the above-mentioned effect.

According to an embodiment, the at least one groove may include a first groove (e.g., a first groove 341 of FIG. 4A) formed in a portion of the connecting portion that contacts the first supporting portion, and a second groove (e.g., a second groove 342 of FIG. 4A) formed in a remaining portion of the connecting portion that contacts the second supporting portion. According to the above-mentioned embodiment, the shield can may include the first groove and the second groove, thereby increasing an area in contact with the solder and reducing separation of the shield can from the printed circuit board. The above-mentioned embodiment may have various effects including the above-mentioned effect.

According to an embodiment, the first supporting portion may extend in a first direction toward the connecting portion. The second supporting portion may extend in a second direction different from the first direction toward the connecting portion. The connecting portion may include a first portion (e.g., the first portion 331 of FIG. 4A) extending from the first supporting portion in the first direction, a second portion (e.g., the second portion 332 of FIG. 4A) extending from the second supporting portion in the second direction, and a third portion (e.g., the third portion 333 of FIG. 4A) connecting the first portion and the second portion and being bent. According to the above-mentioned embodiment, the connecting portion may include the first portion and the second portion, thereby reducing damage to the connecting portion due to an external impact and reducing peeling of the connecting portion from the solder in contact with the connecting portion. The above-mentioned embodiment may have various effects including the above-mentioned effect.

According to an embodiment, the solder may be in contact with the first portion and the second portion from among the first portion, the second portion, and the third portion at a position where the connecting portion is adjacent to the printed circuit board. The third portion of the connecting portion may be in contact with the printed circuit board. According to the above-mentioned embodiment, the solder may be in contact with the first portion and the second portion, thereby reducing a force transferred from the solder to the connecting portion due to an external impact. The third portion may be in contact with the printed circuit board, thereby reducing exposure of at least one electronic component surrounded by the shield can to an electromagnetic wave generated from another electronic component and/or external noise of the shield can. The above-mentioned embodiment may have various effects including the above-mentioned effect.

According to an embodiment, the solder may further include a curved region (e.g., the region 415 of FIG. 4A and the region 425 of FIG. 4B) that is disposed along a periphery of the third portion at a position adjacent to the printed circuit board and is in contact with the third portion. According to the above-mentioned embodiment, the solder may include the curved region in contact with the third portion, thereby reducing peeling of the third portion from the solder and reducing separation of the connecting portion including the third portion from the printed circuit board. The above-mentioned embodiment may have various effects including the above-mentioned effect.

According to an embodiment, the sidewall may further include a slit (e.g., the slit 355 of FIG. 4C) that is surrounded by the connecting portion, the first supporting portion, and the second supporting portion at a position adjacent to the printed circuit board and extends from an outer surface of the shield can to an inner surface of the shield can. According to the above-mentioned embodiment, the sidewall may include the slit, thereby increasing an area in which the shield can is in contact with the solder and reducing separation of the shield can from the printed circuit board. The above-mentioned embodiment may have various effects including the above-mentioned effect.

According to an embodiment, an inner surface (e.g., the inner surface 355a of the slit of FIG. 4C) of the slit may include a side surface of the flange portion. According to the above-mentioned embodiment, as the inner surface of the slit includes the side surface of the flange portion, the slit may increase an area in which the shield can is in contact with the solder and reduce separation of the shield can from the printed circuit board. The above-mentioned embodiment may have various effects including the above-mentioned effect.

According to an embodiment, the solder may include a first region, disposed along a periphery of the sidewall adjacent to the printed circuit board, contacting the outer surface of the shield can, a second region contacting the inner surface of the shield can, and a third region, contacting the inner surface of the slit, extending from the first region to the second region.

According to an embodiment, the connecting portion may be perpendicular to the printed circuit board. According to the above-mentioned embodiment, the connection portion may be perpendicular to the printed circuit board, thereby reducing peeling of the connecting portion from the solder in contact with the connecting portion and reducing separation of the shield can including the connecting portion from the printed circuit board. The above-mentioned embodiment may have various effects including the above-mentioned effect.

According to an embodiment, the base may include a through hole (e.g., the through hole 301a of FIG. 5) penetrating the base. According to the above-mentioned embodiment, the shield can may include the through hole, thereby providing a path through which at least one electronic component surrounded by the shield can may be connected to an external electronic component of the shield can. The above-mentioned embodiment may have various effects including the above-mentioned effect.

According to an embodiment, the flange portion may have a curvature that is bent from an inner surface of the shield can. According to the above-mentioned embodiment, as the flange portion has a curvature, the shield can may reduce damage to a portion including the flange portion adjacent to the printed circuit board from external impact. The above-mentioned embodiment may have various effects including the above-mentioned effect.

According to an embodiment, the connecting portion may include at least one groove connected from an outer surface of the shield can to an inner surface of the shield can at a position adjacent to the printed circuit board and the flange portion. A size (e.g., the size s1 of FIG. 4A) of the at least one groove may be located within a range of 0.04 mm² or more and 0.09 mm² or less. According to the above-mentioned embodiment, the shield can may reduce the exposure of the at least one electronic component surrounded by the shield can to the electromagnetic wave generated from the other electronic component and/or the external noise of the shield can as the size of the at least one groove is located within the range of 0.04 mm² or more and 0.09 mm² or less.

According to an embodiment, a length (e.g., the length d of FIG. 4A) of the flange portion extending from the sidewall toward the outside of the shield can may be located within a range of 0.05 mm or more and 0.1 mm or less. According to the above-mentioned embodiment, the flange portion may reduce damage to the portion of the shield can including the flange portion adjacent to the printed circuit board from the external impact as the length of the flange portion is located within the range of 0.05 mm or more and 0.1 mm or less. The above-mentioned embodiment may have various effects including the above-mentioned effect.

An electronic device according to an embodiment may comprise a printed circuit board, a shield can disposed on the printed circuit board, and a solder in contact with the printed circuit board and the shield can to fasten the shield can to the printed circuit board. The shield can may include a base faced away from the printed circuit board and a sidewall disposed along a periphery of the base. The sidewall may include a first supporting portion, a second supporting portion, and a connecting portion that connects the first supporting portion and the second supporting portion and is at least partially bent, the first supporting portion and the second supporting portion are for supporting the shield can using the printed circuit board. Each of the first supporting portion and the second supporting portion may include a flange portion facing an outside of the shield can at a position adjacent to the printed circuit board. The connecting portion may be perpendicular to the printed circuit board. The solder may include a first region, disposed along a periphery adjacent to the printed circuit board of the sidewall and being in contact with an outer surface of the shield can, and a second region in contact with an inner surface of the shield can. According to the above-mentioned embodiment, the shield can may reduce damage to the sidewall due to the external impact and may support the shield can by using the printed circuit board by including the flange portion. As the connecting portion is perpendicular to the printed circuit board, the shield can may reduce peeling of the connecting portion from the solder in contact with the connecting portion and reduce separation of the shield can including the connecting portion from the printed circuit board. The above-mentioned embodiment may have various effects including the above-mentioned effect.

According to an embodiment, the connecting portion may include at least one groove connected from an outer surface of the shield can to an inner surface of the shield can at a position adjacent to the printed circuit board and the flange portion. The solder may further include a third region in contact with an inner surface of the at least one groove and extending from the first region to the second region. According to the above-mentioned embodiment, the shield can may include the at least one groove, thereby increasing an area in contact with the solder and reducing peeling of the shield can from the solder. The solder may include the third region in contact with the inner surface of the at least one groove, thereby reducing peeling of the shield can from the printed circuit board.

According to an embodiment, the flange portion may have a curvature that is bent from an inner surface of the shield can. According to the above-mentioned embodiment, as the flange portion has a curvature, the shield can may reduce damage to a portion including the flange portion adjacent to the printed circuit board from the external impact. The above-mentioned embodiment may have various effects including the above-mentioned effect.

According to an embodiment, the first supporting portion may extend in a first direction toward the connecting portion. The second supporting portion may extend in a second direction different from the first direction toward the connecting portion. The connecting portion may include a first portion extending from the first supporting portion in the first direction, a second portion extending from the second supporting portion in the second direction, and a third portion connecting the first portion and the second portion and being bent. According to the above-mentioned embodiment, the connecting portion may include the first portion and the second portion, thereby reducing damage to the connecting portion due to the external impact and reducing the peeling of the connecting portion from the solder in contact with the connecting portion. The above-mentioned embodiment may have various effects including the above-mentioned effect.

According to an embodiment, the solder may be in contact with the first portion and the second portion from among the first portion, the second portion, and the third portion at a position where the connecting portion is adjacent to the printed circuit board. The third portion of the connecting portion may be in contact with the printed circuit board. According to the above-mentioned embodiment, the solder may be in contact with the first portion and the second portion, thereby reducing a force transferred from the solder to the connection portion due to the external impact. The third part may be in contact with the printed circuit board, thereby reducing exposure of at least one electronic component surrounded by the shield can to an electromagnetic wave generated from another electronic component and/or external noise of the shield can.

According to an embodiment, the sidewall may further include a slit that is surrounded by the connecting portion, the first supporting portion, and the second supporting portion at a position adjacent to the printed circuit board and extends from an outer surface of the shield can to an inner surface of the shield can. According to the above-mentioned embodiment, the sidewall may include the slit, thereby increasing an area in which the shield can is in contact with the solder and reducing separation of the shield can from the printed circuit board. The above-mentioned embodiment may have various effects including the above-mentioned effect.

According to an embodiment, the base may include a through hole penetrating the base. According to the above-mentioned embodiment, the shield can may include the through hole, thereby providing a path through which at least one electronic component surrounded by the shield can may be connected to an external electronic component of the shield can. The above-mentioned embodiment may have various effects including the above-mentioned effect.

According to an embodiment, a shield can may comprise a base and a sidewall. The sidewall may include a first supporting portion, a second supporting portion, and a connecting portion that connects the first supporting portion and the second supporting portion and is at least partially bent, the first supporting portion and the second supporting portion are disposed along a periphery of the base and are for supporting the shield can. Each of the first supporting portion and the second supporting portion may include a flange portion that is spaced apart from the base 301 and includes a step. The connecting portion has a planar shape at a position adjacent to the flange portion. According to the above-mentioned embodiment, the shield can may reduce damage to the sidewall due to the external impact and may support the shield can by including the flange portion. As the connecting portion, which is at least partially bent, has a planar shape at the position adjacent to the flange portion, the shield can may reduce peeling of the shield can in contact with the solder from the solder and may reduce separation of the shield can from the printed circuit board. The above-mentioned embodiment may have various effects including the above-mentioned effect.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101), comprising:
a printed circuit board (250);
a shield can (300) disposed on the printed circuit board (250); and
a solder (400) in contact with the printed circuit board (250) and the shield can (300) to fasten the shield can (300) to the printed circuit board (250);
wherein the shield can (300) includes:
a base (301) faced away from the printed circuit board (250); and
a sidewall (350) including a first supporting portion (310), a second supporting portion (320), and a connecting portion (330) that connects the first supporting portion (310) and the second supporting portion (320) and is at least partially bent, the first supporting portion (310) and the second supporting portion (320) are disposed along a periphery of the base (301) and are for supporting the shield can (300) using the printed circuit board (250),
wherein each of the first supporting portion (310) and the second supporting portion (320) includes a flange portion (305; 315; 325) facing an outside of the shield can (300) at a position adjacent to the printed circuit board (250),and
wherein the connecting portion (330) has a planar shape at a position adjacent to the printed circuit board (250).

2. The electronic device (101) of claim 1,
wherein the connecting portion (330) includes at least one groove (340; 341; 342) connected from an outer surface (300a) of the shield can (300) to an inner surface (300b) of the shield can (300) at a position adjacent to the printed circuit board (250) and the flange portion (305; 315; 325), and
wherein the solder (400) is in contact with an inner surface (340a; 341a; 342a) of the at least one groove (340; 341; 342).

3. The electronic device (101) of claim 1 or claim 2,
wherein the solder (400) includes:
a first region (410), disposed along a periphery of the sidewall (350) adjacent to the printed circuit board (250), contacting the outer surface (300a) of the shield can (300);
a second region (420) contacting the inner surface (300b) of the shield can (300); and
a third region (430), contacting the inner surface (340a; 341a; 342a) of the at least one groove (340; 341; 342), extending from the first region (410) to the second region (420).

4. The electronic device (101) of any one of claims 1 to 3,
wherein the at least one groove (340; 341; 342) includes:
a first groove (341) formed in a portion of the connecting portion (330) that contacts the first supporting portion (310); and
a second groove (342) formed in a remaining portion of the connecting portion (330) that contacts the second supporting portion (320).

5. The electronic device (101) of any one of claims 1 to 4,
wherein the first supporting portion (310) extends in a first direction toward the connecting portion (330),
wherein the second supporting portion (320) extends in a second direction different from the first direction toward the connecting portion (330), and
wherein the connecting portion (330) includes:
a first portion (331) extending from the first supporting portion (310) in the first direction;
a second portion (332) extending from the second supporting portion (320) in the second direction; and
a third portion (333) connecting the first portion (331) and the second portion (332) and being bent.

6. The electronic device (101) of any one of claims 1 to 5,
wherein the solder (400) is in contact with the first portion (331) and the second portion (332) from among the first portion (331), the second portion (332), and the third portion (333) at a position where the connecting portion (330) is adjacent to the printed circuit board (250), and
wherein the third portion (333) of the connecting portion (330) is in contact with the printed circuit board (250).

7. The electronic device (101) of any one of claims 1 to 6,
wherein the solder (400) further includes a curved region (415; 425) that is disposed along a periphery of the third portion (333) at a position adjacent to the printed circuit board (250) and is in contact with the third portion (333).

8. The electronic device (101) of any one of claims 1 to 7,
wherein the sidewall (350) further includes a slit (355) that is surrounded by the connecting portion (330), the first supporting portion (310), and the second supporting portion (320) at a position adjacent to the printed circuit board (250) and extends from an outer surface (300a) of the shield can (300) to an inner surface (300b) of the shield can (300).

9. The electronic device (101) of any one of claims 1 to 8,
wherein an inner surface (355a) of the slit (355) includes a side surface (305a; 315a; 325a) of the flange portion (305; 315; 325).

10. The electronic device (101) of any one of claims 1 to 9,
wherein the solder (400) includes:
a first region (410), disposed along a periphery of the sidewall (350) adjacent to the printed circuit board (250), contacting the outer surface (300a) of the shield can (300);
a second region (420) contacting an inner surface (300b) of the shield can (300), and
a third region (430), contacting an inner surface (355a) of the slit (355), extending from the first region (410) to the second region (420).

11. The electronic device (101) of any one of claims 1 to 10,
wherein the connecting portion (330) is perpendicular to the printed circuit board (250).

12. The electronic device (101) of any one of claims 1 to 11,
wherein the base (301) includes a through hole (301a) penetrating the base (301).

13. The electronic device (101) of any one of claims 1 to 12,
wherein the flange portion (305; 315; 325) has a curvature that is bent from an inner surface (300b) of the shield can (300).

14. The electronic device (101) of any one of claims 1 to 13,
wherein the connecting portion (330) includes at least one groove (340; 341; 342) connected from an outer surface (300a) of the shield can (300) to an inner surface (300b) of the shield can (300) at a position adjacent to the printed circuit board (250) and the flange portion (305; 315; 325),
wherein a size (s1) of the at least one groove (340; 341; 342) is located within a range of 0.04 mm² or more and 0.09 mm² or less.

15. The electronic device (101) of any one of claims 1 to 14,
A length (d) of the flange portion (305; 315; 325) extending from the sidewall (350) toward the outside of the shield can (300) is located within a range of
0.05 mm or more and 0.1 mm or less.
